# EUROPEAN PATENT SPECIFICATION

(11) **EP 0 492 583 B1**
(45) Date of publication and mention of the grant of the patent: **05.03.1997**
(21) Application number: 91122122.4
(22) Date of filing: 23.12.1991
(51) Int. Cl.: C08J 7/06, C23C 14/06, C03C 8/14, B65D 65/42

(54) **Method of coating the surface of polymeric articles with inorganic films**
Verfahren zur Oberflächenbeschichtung von Polymeren Gegenständen mit anorganischen Filmen
Procédé pour revêtir des articles polymères avec les films inorganiques

(30) Priority: 24.12.1990 IT 2253990
(43) Date of publication of application: 01.07.1992
(73) Proprietor: ENICHEM S.p.A., I-20124 Milano (IT)
(72) Inventor: Occhiello, Ernesto, Dr., I-28100 Novara (IT); Morra, Marco, Dr., I-14040 Cortiglione, Asti (IT); Garbassi, Fabio, Dr., I-28100 Novara (IT)
(74) Representative: Barz, Peter, Dr.

(56) References cited:
- WO-A-80/00970
- CH-A- 350 975
- DATABASE WPIL Section Ch, Week 8549, Derwent Publications Ltd., London, GB; Class A08, AN 85-305938 ; & JP-A-60 210 641
- PATENT ABSTRACTS OF JAPAN,vol. 12, no. 316 (C-524)1988 ; JP-A-63 086 860
- E.B. SHAND 'GLASS ENGINEERING HANDBOOK' , MCGRAW-HILL , NEW-YORK

## Description

The present invention relates to a method of coating the surface of articles (bodies) made of polymeric material with inorganic films.

More particularly, the present invention relates to a method of coating the surface of articles of polymeric material with inorganic films, by evaporating glass/silicon mixtures.

The term "articles of polymeric material", as used in the present description and the appended claims is to denote articles (bodies) of any shapes and sizes which are obtainable by means of known thermoplastic polymer processing techniques such as extrusion, injection moulding, "blow-moulding", "roto-moulding", etc. Examples of articles employable in the present invention are films, sheets, panels, plates, containers, etc., obtained from polymers such as polyolefins (e.g. low-, medium- or high-density polyethylene and polypropylene), polystyrenes, poly(vinyl chloride), polyesters (e.g. polyethylene terephthalate and polybutylene terephthalate), polycarbonates, polyamides, poly(meth)acrylates, or mixtures thereof, etc.

It is known from the prior art that characteristics such as wettability, haze resistance, gas and vapour barrier properties and selective absorption of ultraviolet light, can be imparted by vacuum deposition of inorganic layers on the surface of articles of polymeric materials. Examples of such technologies are given in "Thin Film Processes", edited by J.L. Vossen and W. Kern, Academic Press, New York, 1978.

It is furthermore known that, among the vacuum deposition techniques, thermal evaporation is preferred, thanks to the high deposition rate achievable and to the very low industrial costs of the corresponding treatment. Processes for depositing inorganic oxide layers on the surface of articles of polymeric materials by means of evaporation are disclosed, e.g., in US-A-3,442,686, wherein the use of several oxides, among which SiO, SiO₂, Al₂O₃, ZrO₂ and iron oxides may be mentioned, is described.

More recently the evaporation of glass on products made of polymeric materials, in particular polyester films and bottles and polycarbonate substrates, has been described in JP-A-62-23744 and WO 80/00970.

Finally, GB-A-2,211,516 and CH-A-350 975 describe processes for depositing mixtures of silicon and silicon oxide on thermoplastic films, by means of vacuum evaporation.

While in the prior art cited hereinabove it is stated that better gas barrier characteristics can be obtained by means of the deposition of inorganic surface layers, in later references (e.g., in JP-A-60-210641) the obtainment of a better haze resistance by means of deposition of silicon oxide-based layers, or the obtainment of a better wettability is reported (JP-A-50-51180).

Finally, the dependence of optical and barrier properties of silicon oxide-based layers on the ratio of oxygen to silicon has been reported in a paper presented by T.G. Krug and K. Ruebsam at the Barrier Pack Conference, London, May 21 to 22, 1990. In this paper it is stated that optimum property combinations are obtained with an oxygen to silicon ratio of from 1.5:1 to 1.8:1.

None of the above documents discloses the use of silicon and glass-based mixtures as used in the present invention as compositions to be evaporated and deposited in order to obtain coatings with the above properties.

It has now been found that the use of such mixtures allows, as observed in the references cited hereinabove, to control surface-depending properties such as wettability, haze resistance, gas and vapour barrier properties and selective absorption of ultraviolet light. At the same time, surprising and substantial increases in deposition rate can additionally be observed, the possibility of being able to use two inexpensive, readily available materials (glass and silicon) being a further advantage.

Accordingly, the object of the present invention is a method of coating the surface of articles of polymeric material with inorganic films, which method comprises depositing, on said surface, a (thin) layer by means of thermal evaporation, under vacuum, of glass for glassware silicon mixtures (glass:silicon weight ratio from 1:0.25 to 1:8) in the molten state.

According to a preferred embodiment the glass/silicon weight ratio ranges from 1:0.5 to 1:4, still more preferred from 1:0.5 to 1:1.25. The evaporation is usually carried out in the presence of an excess of silicon with respect to glass, in order to compensate the oxidative effects due to the presence of oxidizing components in the residual vacuum atmosphere.

More in particular, the sequence of physical and chemical events which take place according to the present process can be summarized as follows:
(i) glass for glassware and silicon are melted, inside a vacuum chamber, in order to obtain a homogeneous molten mass;
(ii) silicon-(IV) and silicon-(0) are reacted to essentially yield silicon-(II) oxide, as described in "The Oxide Handbook" by G.V. Samsonov, published by IFI/Plenum, New York 1973, page 364;
(iii) silicon-(0), silicon-(II) oxide and other possible glass-component oxides are evaporated;
(iv) the oxides (iii) are (partially) oxidized in the vapour phase by the residual oxygen present in the vacuum chamber to essentially yield SiO; and
(v) the vapours are deposited onto the article of polymeric material, to yield a layer having a thickness usually comprised within the range of from 1 to 1,000 nm.

The mixture to be applied by evaporation is composed of glass for glassware and silicon. It is possible to use conventional bottle glass or also glasses generally known as "Pyrex". As regards silicon, a particular purity is not absolutely necessary; for example, silicon known as "metallurgical grade silicon" can be used.

Furthermore, a preliminary, particularly accurate grinding of the components is not necessary because already the melting of glass and silicon yields a homogeneous mixture. The melting process may be accomplished in a melting pot of conductive, high temperature-resistant material (such as, for example, graphit, tungsten, tantalum, etc.); through said melting pot, a current is caused to flow, the value of which is sufficient to cause the mixture to melt (melting by Joule effect).

The use of glass instead of crystalline silicon oxides allows to obtain the molten mixture at melting temperatures which are approximately 800 to 1000°C lower than the silica melting temperature, as taught, for example, by E.B. Shand in "Glass Engineering Handbook", McGraw-Hill, New York, 1958, page 12. This allows, first of all, to achieve silicon-(IV) oxide melting at a temperature which is compatible with the silicon melting temperature, thus making possible a much better homogenization of the reaction mixture as well as a considerable energy saving.

In addition, the chemistry of the layer can be controlled, first of all, by varying the glass to silicon weight ratio, which may result in a molar ratio of silicon-(IV) to silicon(0) within the range of from 0.05:1 to 1.7:1, or also in an atomic ratio of oxygen to silicon within the optimum range of from 0.1:1 to 1.5:1. A second way of controlling the chemistry of the layer consists in the modification of the pressure of the reaction environment; the higher said pressure, the larger will be the amounts of residual oxygen and water vapour which can react with the evaporated substances in the gas phase.

Optimum pressure values for carrying out the method of the present invention range from 10⁻⁵ to 1 Pa, preferably from 10⁻³ to 10⁻¹ Pa.

The deposited inorganic surface layer usually has a thickness of from 1 to 1000 nm, preferably from 5 to 150 nm, depending on the intended application. In fact, from the prior art it is well-known that for applications in which the deposited layer is to perform the function of a gas barrier, thickness values higher than 40 nm are preferred (see T.G. Krug and K. Ruebsam, ibid.). It is furthermore known that the properties associated with wettability depend on the first molecular layer of each material, as taught by W.A. Zisman in "Advances in Chemistry Series", Volume No. 43, published by the American Chemical Society, Washington, 1964, pages 6-7. Anyway, in order to secure the uniformity of the deposited layer, for such applications a layer having a thickness of at least 5 nm is preferable, while its chemical composition will be such that the O/Si ratio is within the range of from 1.5:1 to 1.8:1 because said range, as reported by T.G. Krug and K. Ruebsam, affords an optimum compromise between the various properties to be imparted by the coating.

The method of the present invention allows to obtain deposition rates which depend on the equipment used, said rates being in general higher than 3 nm/s, for example ranging from 3 to 100 nm/s. The present method is particularly suitable for treating articles to be used in the field of food packaging. In fact, in said field both gas and vapour barrier properties, in particvular oxygen barrier properties, and satisfactory wettability or ultraviolet light barrier properties are very important.

Another field in which the present method can be advantageously used is the field of coatings for greenhouses and agricultural cultivations wherein the prevention of haze, which keeps the sunlight from shining upon the cultivations, is particularly important.

In general, articles of polymeric material modified by means of the present method can advantageously be used in all fields wherein gas and vapour barrier properties or ultraviolet light barrier properties, a high wettability and a high haze resistance, are required.

The following examples are to further illustrate the present invention.

In all the examples a cylindrical vacuum chamber (manufactured by Kenotec of Binasco [MI, Italy]) having an internal diameter of about 40 cm and a height of 30 cm was used. The vacuum inside the reactor was effected by a pumping device capable of reaching pressure values of the order of 10⁻⁵ Pa. Tantalum melting pots of standard size (50 x 10 x 0.15 mm) and available from Goodfellow, Cambridge, U.K. were used. The evaporation was effected by converting an alternating current (at 50 Hz) from 220 V to 6 V (frequency 50 Hz, intensity 100 A) by means of a transformer supplied by Elettromeccanica Verbano, Novara, Italy.

### COMPARATIVE EXAMPLE

The evaporation characteristics of some oxide mixtures suggested in the prior art, in particular silicon-(II) oxide, silicon/silicon-(IV) oxide and glass mixtures were compared.

Silicon-(II) oxide and silicon-(IV) oxide were purchased from Aldrich Chemical, Milwaukee, Wisconsin, U.S.A. Conventional glass for chemical glassware was purchased from Schott, Mainz, Germany.

For all evaporation processes, the vacuum chamber and the current source described hereinabove were used. The pressure inside the vacuum chamber was maintained at 3 x 10⁻² Pa. The oxide mixtures were charged to the tantalum melting pots positioned at a distance of 125 mm from the sample. The samples consisted of aluminum sheets or bi-oriented PET films (Melinex® 800, thickness 12 µm, ICI, WILTON, U.K.). In all cases the oxides were charged to the melting pots in amounts such as to obtain a total number of gram-atoms of 4.92 x 10⁻³.

First the deposition rate of different oxide mixtures under the same experimental conditions was studied. The deposition rates were measured by means of a quartz microbalance (model IL100, Intellemetrics, Clydebank, U.K.) by using the values of density and acoustical impedance of SiO₂ indicated by the manufacturer of the instrument. The different geometrical position relative to the sample and possible differences deriving from the chemical composition of the deposited layer were compensated for by means of a calibration by Auger Profile, according to the following procedure (said procedure was repeated for the various types of evaporated materials):
- a deposition on aluminum was carried out, the thickness read by the quartz microbalance being simultaneously recorded;
- the coated aluminum sample was subjected to the testing for Auger Profile (according to the method described by J.M. Morabito and R.K. Lewis in "Methods of Surface Analysis", edited by A.W. Czanderna, Elsevier, Amsterdam 1975, pages 279-328) by means of a spectrometer (XPS-AES PHI 548, Perkin Elmer, Eden Prairie, Minnesota, USA), the latter having previously been calibrated by means of standards consisting of Si₃N₄ layers on Si with a known thickness;
- the thickness values obtained by means of the Auger Profile were compared to those obtained by means of the quartz microbalance. A further conversion into deposition rate values was carried out, and the correction factor was used for subsequent experiments.

In Table 1 below the deposition rate values obtained for different kinds of evaporated material are reported.

**TABLE 1**

| Evaporated material | Deposition Rate (nm/s) |
|---|---|
| SiO | 1.0 |
| Glass | 0.8 |
| Si/SiO₂ 1:1 | 2.6 |

The deposition processes carried out with the above oxides were repeated with polymeric substrates, in particular with PET films, and the resulting samples were analysed by means of electronic X-ray spectrometry (XPS, a method described in "Practical Surface Analysis", by M. Seah and D. Briggs, Wiley, New York, 1983, pages 359-396), using the above instrument, thereby obtaining the values of the O/Si ratio reported in Table 2 below.

**TABLE 2**

| Evaporated material | Thickness (nm) | XPS O/Si |
|---|---|---|
| SiO | 25 | 1.5 : 1 |
| Glass | 12 | 2.1 : 1 |
| Si/SiO₂ 1:1 | 90 | 1.3 : 1 |

### EXAMPLE 1

Evaporation processes were carried out on glass/silicon mixtures, with various ratios of the components. The glass described in the above comparative example was used while silicon supplied by Monsanto Electronic Materials Company, Novara, Italy was employed.

The same experimental procedures as described in the comparative example were used; in particular, the number of gram-atoms charged to the melting pot in each evaporation process was kept constant and equal to the value specified hereinabove.

The evaporation rate values were determined as reported in the comparative example, i.e. by jointly using a quartz microbalance and Auger Profiles. In Table 3 below the obtained evaporation rate values are reported, said values being considerably higher than those reported in Table 1 above.

**TABLE 3**

| Weight ratio glass/silicon | Atomic ratio O/Si | Deposition rate (nm/s) |
|---|---|---|
| 1 : 0.25 | 1.36 : 1 | 3.2 |
| 1 : 0.5 | 0.99 : 1 | 3.1 |
| 1 : 0.75 | 0.78 : 1 | 4.5 |
| 1 : 1 | 0.64 : 1 | 4.5 |
| 1 : 2 | 0.38 : 1 | 3.7 |
| 1 : 4 | 0.21 : 1 | 4.5 |
| 1 : 8 | 0.11 : 1 | 3.5 |

Some samples obtained in the above way were analysed by XPS, according to the method described in the comparative example and the O/Si ratios thus obtained are reported in Table 4.

**TABLE 4**

| Weight ratio glass/silicon | Atomic ratio O/Si (by XPS) |
|---|---|
| 1 : 0.5 | 1.8 |
| 1 : 1 | 1.7 |
| 1 : 4 | 1.3 |
| 1 : 8 | 1.2 |

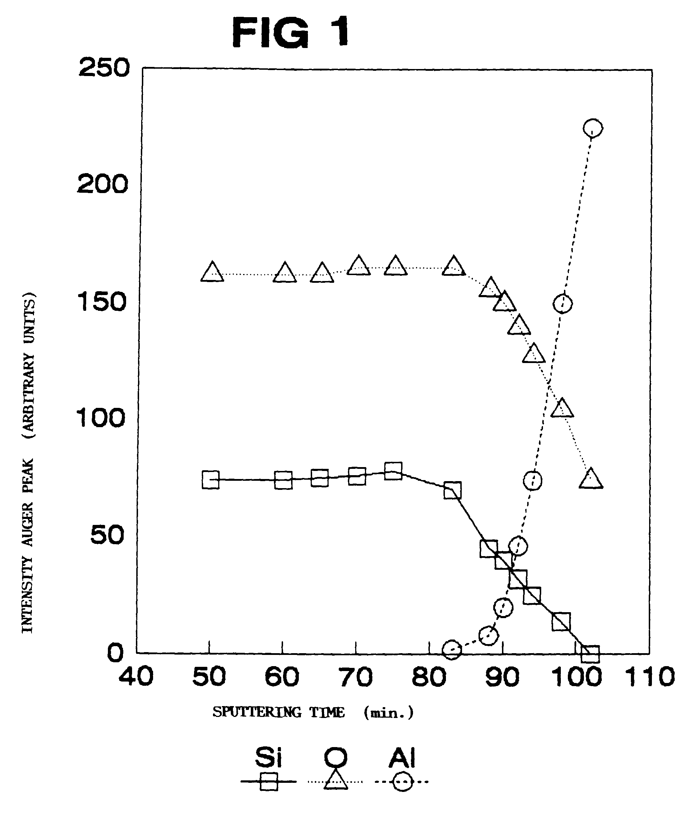

A sample was subsequently prepared by depositing a layer from a glass/silicon mixture in the weight ratio of 1:1, whereafter said sample was subjected to chemical analysis by Auger Profile. Aluminum was selected as the substrate because said technique requires a conductive substrate, but as those skilled in the art are well aware of, said substrate does in no way influence the chemistry of the surface layer. The obtained results are graphically represented in Figure 1, from which one can see that the intensity of the peaks relating to silicon and oxygen is not variable up to the vicinity of the interface. Said result evidences a constant chemical composition of the deposited layer.

### EXAMPLE 2

Samples for wettability measurements were prepared by evaporating the mixtures described in the comparative example and in example 1, with thicknesses ranging from 5 to 300 nm being used. The above PET films and films of mono-oriented polyamide-6 (thickness 18 µm, manufactured by Fapack, Pisticci, Italy) and of low-density polyethylene (thickness 50 µm, Eraclene® QG 6015, manufactured by Enimont Materials, Milan, Italy), were used as substrates.

The advancing contact angles (a.a.) and receding angles (r.a.) for water were then measured by means of a contact angle measuring instrument manufactured by Ramé-Hart (Mountain Lakes, New Jersey, U.S.A.). THe sessile drop method, according to the procedure taught by S. Wu in "Polymer Interface and Adhesion", Marcel Dekker, New York 1982, pages 257-260, was used.

The observed advancing angle values for the component with the lowest surface wettability determined as reported by S. Wu ibid. were comprised within the range of from 0° to 30°, while the receding angle values for the component with the highest surface wettability ranged from 0° to 10°. A dependence from the substrate, from the O/Si ratio or from the thickness of the deposited layer was not observed, while a dependence, in contrast, was observed as regards storage conditions, relative humidity etc. Said observations are in accordance with the behaviour of the contact angle values on inorganic oxide surfaces as discussed by S. Wu, ibid., pages 224-228.

The contact angles of water on non-treated substrates are those reported in Table 5. It can be seen that the surface treatment causes a drastic increase in the wettability thereof.

**TABLE 5**

| Material | Advancing Angle (°) | Receding Angle (°) |
|---|---|---|
| PET | 78 | 41 |
| PA | 52 | 13 |
| LDPE | 96 | 78 |

### EXAMPLE 3

Samples for measurements of the adhesion of the coating to the substrate were prepared by using the above PET films as the substrate, under the evaporation conditions disclosed in example 1, with weight ratios of glass/silicon and thicknesses as reported in detail in Table 6 below.

The values of adhesion of the coating to the polymeric film were evaluated by means of the tear strength test. The experimental instrument used (Sebastian II, Quad Group of Spikane, Washington, USA) comprised, first of all, aluminum punches coated with an epoxy adhesive, which was caused to adhere to the coated surface. The film was then mounted, in its turn, with its non-treated side, on a metallic support. The instrument used was also capable of exerting an increasing tensile stress, up to cohesive or adhesive breakage of the joint.

As reported in Table 6 below, with the non-treated sample an adhesive breakage occured, i.e., the metallic punch became detached from the film. With all treated samples, on the contrary, film tearing occurred, i.e., a cohesive breakage resulted. This involves two, both positive, distinct effects. The first of them is an increase in the adhesion of the film surface to the adhesives, i.e., an increase in the adhesion strength of the treated films as compared to the adhesion strength of the non-treated ones. The second effect is due to the fact that the interface between polymeric film and deposited layer is particularly strong, so as to cause a cohesive breakage of the polymeric film.

**TABLE 6**

| Weight ratio glass/silicon | Thickness (nm) | Type of failure |
|---|---|---|
| Untreated PET | -- | adhesive |
| 1 : 0.5 | 39 | cohesive |
| 1 : 0.5 | 126 | cohesive |
| 1 : 1 | 99 | cohesive |
| 1 : 1 | 150 | cohesive |
| 1 : 1 | 205 | cohesive |
| 1 : 2 | 54 | cohesive |
| 1 : 2 | 169 | cohesive |

### EXAMPLE 4

A 1:1 glass/silicon mixture (which makes is possible to achieve particularly high deposition rates) was used to deposit (according to the procedures reported in example 1) inorganic layers on PET, polyamide-6 and low-density polyethylene films, as described in example 2.

The effect on haze resistance of said treatment was then evaluated by means of the experimental apparatus described in the following. The polymeric material (film supported by means of a frame) was positioned, at a distance of 20 cm in height, above a crystallizer inside which an amount of water was caused to boil. The angle formed by the line perpendicular to the support plane and the line perpendicular to the film plane was about 60°. The film was irradiated on one side by means of a variable intensity lamp. On the other side of the film an optical fibre was positioned, which transferred the transmitted light to a multichannel spectrum analyzer. The radiation with wavelengths ranging from 254 to 840 nm was collected, and the spectrum thereof was transmitted to a computer which carried out the integration of the signal, i.e., counted the transmitted photons. The measurements of the transmitted light were carried out when the H₂O reached a high boiling rate and the amount of water vapour present was such as to homogeneously impinge onto the polymeric surface. For each measurement 5 spectra were recorded, with an exposure time of 1 second, at time intervals of 30 seconds. The measurement result was expressed (in percent) as the average number of photons transmitted in the 5 recorded spectra as compared to the number of photons transmitted in the absence of water vapour. The obtained values are reported in Table 7. From said table, it can clearly be taken that substantial improvements were obtained as regards wettability and haze resistance characteristics, which did not noticeably depend on the thickness of the deposited layer.

**TABLE 7**

| Material | Thickness (nm) | Haze Resistance (%) |
|---|---|---|
| PET | - | 65 |
| | 37 | 96 |
| | 94 | 96 |
| | 170 | 95 |
| PA | - | 78 |
| | 39 | 94 |
| | 84 | 95 |
| | 280 | 94 |
| LDPE | - | 51 |
| | 168 | 98 |

### EXAMPLE 5

The above 1:1 glass/silicon mixture was used to deposit (according to the procedures reported in example 1) inorganic layers on PET, polyamide-6 and low-density polyethylene films as described in example 2.

The UV and visible light spectra (200-600 nm) were recorded by means of a spectrometer (model UV-160, manufactured by Shimadzu, Japan).

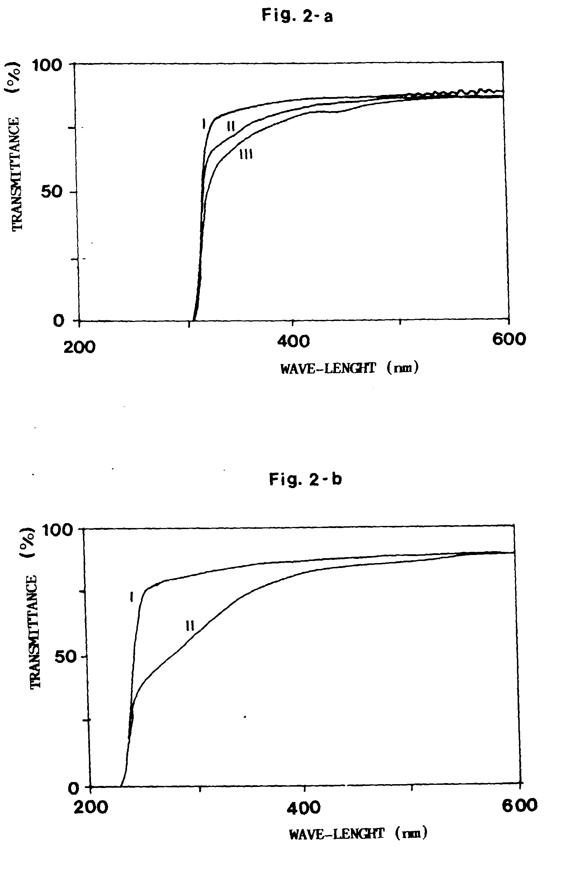

In Figure 2-a, the spectra relating to non-treated PET (line "I") and PET coated with a layer having a thickness of 72 nm (line "II") and 148 nm, resp., (line "III") are shown. In Figure 2-b the spectra relating to non-treated polyamide-6 (line "I") and polyamide-6 coated with a layer having a thickness to 280 nm (line "II"), are depicted.

From the results obtained it is evident that, in the case of treated films, the transmission values are decreased at wave-lengths shorter than 400 nm, said decrease being a function of the thickness of the layer applied.

## Claims

1. Method of coating the surface of articles of polymeric materials with inorganic films, comprising the deposition, on said surface, of a layer by thermal evaporation, under vacuum, of molten glass for glassware/silicon mixtures having a glass:silicon weight ratio of from 1:0.25 to 1:8.

2. Method according to claim 1, wherein the glass/silicon weight ratio ranges from 1 : 0.5 to 1 : 4, particularly from 1 : 0.5 to 1 : 1.25.

3. Method according to any one of claims 1 and 2, wherein the molten silicon/glass mixture is at a temperature which is about 800 to 1000°C lower than the melting temperature of silica.

4. Method according to any one of the preceding claims, wherein the thermal evaporation is carried out under a pressure of from 10⁻⁵ to 1 Pa, particularly of from 10⁻³ to 10⁻¹ Pa.

5. Method according to any one of the preceding claims, wherein the inorganic layer has a thickness of from 1 to 1000 nm, particularly of from 5 to 150 nm.

6. Method according to any one of the preceding claims, wherein the deposition of the inorganic film takes place at a rate of at least 3 nm/s.

## Patentansprüche

1. Verfahren zur Beschichtung der Oberfläche von Gegenständen aus polymeren Materialien mit anorganischen Filmen, umfassend die Abscheidung, auf der Oberfläche, einer Schicht durch thermische Verdampfung unter Vakuum von geschmolzenen Glas für Glaswaren/Silicium-Mischungen mit einem Gewichtsverhältnis Glas:Silicium von 1:0,25 bis 1:8.

2. Verfahren nach Anspruch 1, in welchem das Gewichtsverhältnis Glas/Silicium im Bereich von 1:0,5 bis 1:4, insbesondere von 1:0,5 bis 1:1,25, liegt.

3. Verfahren nach irgendeinem der Ansprüche 1 und 2, in welchem sich die geschmolzene Silicium-Glas-Mischung bei einer Temperatur befindet, die etwa 800 bis 1000°C niedriger als die Schmelztemperatur von Siliciumdioxid ist.

4. Verfahren nach irgendeinem der vorangehenden Ansprüche, in welchem die thermische Verdampfung unter einem Druck von 10⁻⁵ bis 1 Pa, insbesondere von 10⁻³ bis 10⁻¹ Pa, durchgeführt wird.

5. Verfahren nach irgendeinem der vorangehenden Ansprüche, in welchem die anorganische Schicht eine Dicke von 1 bis 1000 nm, insbesondere von 5 bis 150 nm, aufweist.

6. Verfahren nach irgendeinem der vorangehenden Ansprüche, in welchem die Abscheidung des anorganischen Filmes mit einer Geschwindigkeit von mindestens 3 nm/s stattfindet.

## Revendications

1. Procédé permettant de revêtir la surface d'articles en matériaux polymères avec des films de matériau inorganique, qui comporte le fait de déposer, sur ladite surface, par évaporation thermique et sous vide, une couche d'un mélange fondu de verre à verrerie et de silicium où le rapport pondéral verre/silicium vaut de 1/0,25 à 1/8.

2. Procédé conforme à la revendication 1, dans lequel le rapport pondéral verre/silicium vaut de 1/0,5 à 1/4, et en particulier de 1/0,5 à 1/1,25.

3. Procédé conforme à l'une des revendications précédentes, dans lequel le mélange fondu de verre et de silicium se trouve à une température qui est inférieure d'environ 800°C à 1000°C au point de fusion de la silice.

4. Procédé conforme à l'une des revendications précédentes, dans lequel on réalise l'évaporation thermique sous une pression de 10⁻⁵ à 1 Pa, et en particulier de 10⁻³ à 10⁻¹ Pa.

5. Procédé conforme à l'une des revendications précédentes, dans lequel l'épaisseur de la couche de matériau inorganique vaut de 1 à 1000 nm, et en particulier de 5 à 150 nm.

6. Procédé conforme à l'une des revendications précédentes, dans lequel on effectue le dépôt du film de matériau inorganique à une vitesse d'au moins 3 nm/s.
